# EUROPEAN PATENT SPECIFICATION

(11) **EP 4 012 855 B1**
(45) Date of publication and mention of the grant of the patent: **19.03.2025**
(21) Application number: 20850937.2
(22) Date of filing: 15.07.2020
(51) Int. Cl.: H01S 5/183, H01S 5/042

(54) **VERTICAL RESONATOR TYPE LIGHT EMITTING ELEMENT**
LICHTEMITTIERENDES VERTIKALRESONATORELEMENT
ÉLÉMENT ÉLECTROLUMINESCENT DE TYPE RÉSONATEUR VERTICAL

(30) Priority: 08.08.2019 JP 2019146049
(43) Date of publication of application: 15.06.2022
(73) Proprietor: STANLEY ELECTRIC CO., LTD., Tokyo 153-8636 (JP)
(72) Inventor: NAKATA, Keisuke, Tokyo 153-8636 (JP); KURAMOTO, Masaru, Tokyo 153-8636 (JP)
(74) Representative: Klang, Alexander H.
(86) International application number: PCT/JP2020/027475
(87) International publication number: WO 2021/024719

(56) References cited:
- WO-A1-2017/047317
- JP-A- 2015 126 040
- JP-A- 2017 098 328
- JP-A- 2017 212 270
- US-A1- 2005 025 211
- US-A1- 2015 311 673
- US-A1- 2018 248 339
- US-B2- 6 836 579
- US-B2- 9 595 810
- HAGLUND Å ET AL: "Progress and challenges in electrically pumped GaN-based VCSELs", PROCEEDINGS OF SPIE; [PROCEEDINGS OF SPIE ISSN 0277-786X VOLUME 10524], SPIE, US, vol. 9892, 28 April 2016 (2016-04-28), pages 98920Y - 98920Y, XP060069735, ISBN: 978-1-5106-1533-5, DOI: 10.1117/12.2229428
- LIU AN-JIN ET AL: "CLASSICAL AREAS OF PHENOMENOLOGY;Graded index profiles and loss-induced single-mode characteristics in vertical-cavity surface-emitting lasers with petal-shape holey structure", CHINESE PHYSICS B, CHINESE PHYSICS B, BRISTOL GB, vol. 20, no. 2, 4 February 2011 (2011-02-04), pages 24204, XP020204564, ISSN: 1674-1056, DOI: 10.1088/1674-1056/20/2/024204

## Description

### TECHNICAL FIELD

The present invention relates to a vertical cavity light-emitting element, such as a vertical cavity surface emitting laser.

### BACKGROUND ART

Conventionally, as one of semiconductor lasers, there has been known a vertical cavity-type surface emitting laser that includes a semiconductor layer for emitting light by application of a voltage and multilayer film reflecting mirrors opposed across the semiconductor layer to one another. In the semiconductor laser, for example, an electrode electrically connected to the semiconductor layer is disposed. For example, JP 2017-98328 A discloses a vertical cavity-type semiconductor laser that has an n-electrode and a p-electrode respectively connected to an n-type semiconductor layer and a p-type semiconductor layer.

US 2018/0248339 A1 discloses a surface light-emitting laser and was used as a basis for the preamble of claim 1. The surface-emitting laser includes a laser element section that includes a first multi-layer film reflecting mirror, a first semiconductor layer of a first conductivity type, an active layer, a second semiconductor layer of a second conductivity type, a second multi-layer film reflecting mirror, a nitride semiconductor layer of the second conductivity type, and a light output surface in this order. The laser element section further includes an electrode that injects a current into the active layer.

### DISCLOSURE OF THE INVENTION

### PROBLEMS TO BE SOLVED BY THE INVENTION

For example, in a vertical cavity light-emitting element, such as a surface emitting laser, an optical resonator is formed by opposing reflecting mirrors. For example, in the surface emitting laser, by applying a voltage to a semiconductor layer via an electrode, light emitted from the semiconductor layer resonates inside the optical resonator, and a laser light is generated.

Here, in order to cause laser oscillation at a low threshold in the surface emitting laser, for example, a current injected into the semiconductor layer via the electrode is preferably converted into light with high efficiency in the semiconductor layer. Therefore, for example, the vertical cavity light-emitting element, such as a surface emitting laser, preferably has an electrode configuration that can inject the current into the semiconductor layer with low resistance.

The present invention has been made in consideration of the above-described points and an object of which is to provide a vertical cavity light-emitting element that performs a highly efficient light-emitting operation by performing a highly efficient current injection.

### SOLUTIONS TO THE PROBLEMS

A vertical cavity light-emitting element according to the present invention is provided as set forth in claim 1. Preferred embodiments of the present invention may be gathered from the dependent claims.

### BRIEF DESCRIPTION OF THE DRAWINGS

FIG. 1 is a top view of a surface emitting laser according to Embodiment 1.
FIG. 2 is a cross-sectional view of the surface emitting laser according to Embodiment 1.
FIG. 3 is a drawing schematically illustrating a current path of the surface emitting laser according to Embodiment 1.
FIG. 4A is a drawing illustrating a manufacturing process of the surface emitting laser according to Embodiment 1.
FIG. 4B is a drawing illustrating a manufacturing process of the surface emitting laser according to Embodiment 1.
FIG. 4C is a drawing illustrating a manufacturing process of the surface emitting laser according to Embodiment 1.
FIG. 4D is a drawing illustrating a manufacturing process of the surface emitting laser according to Embodiment 1.
FIG. 4E is a drawing illustrating a manufacturing process of the surface emitting laser according to Embodiment 1.
FIG. 4F is a drawing illustrating a manufacturing process of the surface emitting laser according to Embodiment 1.
FIG. 4G is a drawing illustrating a manufacturing process of the surface emitting laser according to Embodiment 1.
FIG. 5 is a top view of a surface emitting laser according to Embodiment 2. FIG. 6 is a cross-sectional view of the surface emitting laser according to Embodiment 2.

### DESCRIPTION OF PREFERRED EMBODIMENTS

The following describes embodiments of the present invention in detail. In the following embodiments, a case where the present invention is exploited as a surface emitting laser (semiconductor laser) will be described. However, the present invention is not limited to the surface emitting laser and is applicable to various kinds of vertical cavity light-emitting elements, such as a vertical cavity light-emitting diode.

### [Embodiment 1]

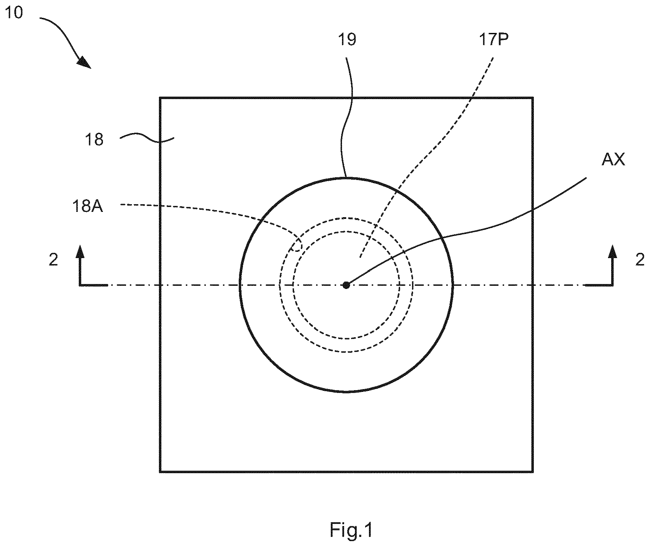

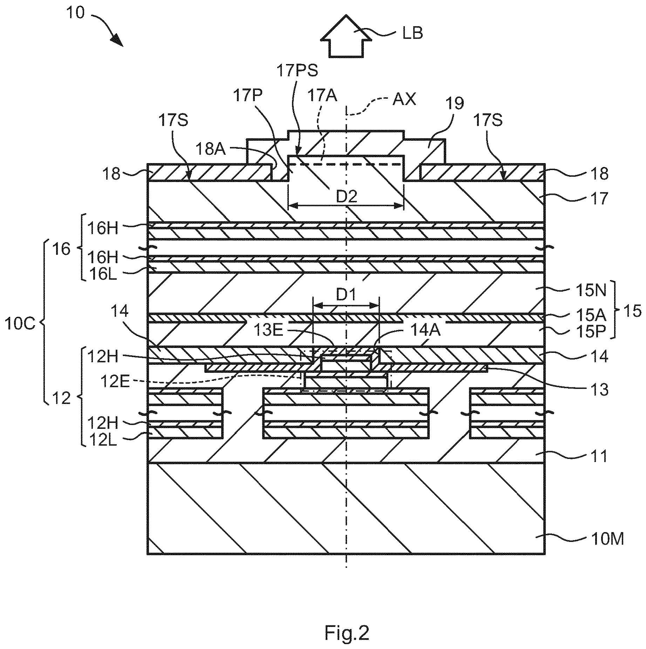

FIG. 1 is a schematic top view of a vertical cavity surface emitting laser (VCSEL, which is hereinafter referred to as a surface emitting laser) according to Embodiment 1. FIG. 2 is a cross-sectional view of the surface emitting laser 10. FIG. 2 is a cross-sectional view taken along the line 2-2 in Fig. 1. Using FIG. 1 and FIG. 2, a configuration of the surface emitting laser 10 will be described.

The surface emitting laser 10 has a mount substrate 10M, a p-electrode (connection electrode) 11 formed on the mount substrate 10M, and a first multilayer film reflecting mirror (hereinafter simply referred to as a first reflecting mirror) 12 formed so as to be embedded in the p-electrode 11 and partially exposed from the p-electrode 11.

In this embodiment, the first reflecting mirror 12 has a structure in which a first dielectric film (hereinafter referred to as a low refractive index dielectric film) 12L and a second dielectric film (hereinafter referred to as a high refractive index dielectric film) 12H having a higher refractive index than the low refractive index dielectric film 12L are alternately laminated. **In** this embodiment, the first reflecting mirror 12 constitutes a distributed Bragg reflector (DBR) made of a dielectric material.

In this embodiment, the p-electrode 11 has an opening portion on an upper surface from which the first reflecting mirror 12 is partially exposed. The first reflecting mirror 12 has an exposed portion 12E that is exposed from the p-electrode 11 while projecting from the p-electrode 11 at the opening portion of the p-electrode 11.

In this embodiment, the first reflecting mirror 12 has a buried multilayer film part embedded in the p-electrode 11 and a projecting multilayer film part projecting so as to decrease in width in stages from the buried multilayer film part. In this embodiment, the projecting multilayer film part is a part of the first reflecting mirror 12 projecting in a cylindrical shape from the buried multilayer film part so as to decrease in diameter in two stages.

Further, in this embodiment, the projecting multilayer film part in the first reflecting mirror 12 has a lower part (lower stepped portion in this embodiment) having a side surface that is covered by the p-electrode 11 and an upper part (upper stepped portion in this embodiment) having a side surface and an upper surface that project from the p-electrode 11 and are exposed. That is, in this embodiment, the exposed portion 12E of the first reflecting mirror 12 includes the upper surface of the lower part of the projecting multilayer film part and the side surface and the upper surface of the upper part. The exposed portion 12E of the first reflecting mirror 12 has a circular shape in a top view.

The surface emitting laser 10 includes a light transmissive electrode (first electrode) 13 formed on the p-electrode 11 while covering the exposed portion 12E of the first reflecting mirror 12. In this embodiment, the first reflecting mirror 12 has a through hole that passes from the mount substrate 10M side to the light transmissive electrode 13 side. The p-electrode 11 passes partially through the first reflecting mirror 12 and is connected to the light transmissive electrode 13. In this embodiment, the first reflecting mirror 12 has the through hole formed in a tubular shape, and the p-electrode 11 passes through the first reflecting mirror 12 in a tubular shape and is connected to the light transmissive electrode 13.

The surface emitting laser 10 includes an insulating layer 14 that is formed on the p-electrode 11 and the light transmissive electrode 13 and has an opening portion 14A exposing the light transmissive electrode 13 on the exposed portion 12E of the first reflecting mirror 12.

In this embodiment, the light transmissive electrode 13 has an exposed portion 13E exposed from the opening portion 14A of the insulating layer 14. In this embodiment, the exposed portion 13E of the light transmissive electrode 13 has a circular-shaped top surface shape.

For example, the mount substrate 10M is made of a material having a high thermal conductivity, for example, a ceramic material such as AlN. The p-electrode 11 is made of a metallic material, such as Au, Al, and Cu. The low refractive index dielectric film 12L in the first reflecting mirror 12 is made of SiO₂, and the high refractive index dielectric film 12H is made of Nb₂O₅. The light transmissive electrode 13 is made of a transparent conductive film, such as ITO and IZO. The insulating layer 14 is made of SiO₂, SiN, and the like.

The surface emitting laser 10 includes an optical semiconductor layer 15 that is formed on the insulating layer 14 and connected to the exposed portion 13E of the light transmissive electrode 13 at the opening portion 14A of the insulating layer 14. For example, the optical semiconductor layer 15 includes a plurality of semiconductor layers made of a nitride semiconductor. The exposed portion 13E of the light transmissive electrode 13 functions as a contact region that electrically connects the light transmissive electrode 13 (p-electrode 11) to the optical semiconductor layer 15.

In this embodiment, the optical semiconductor layer 15 includes a p-type semiconductor layer (first semiconductor layer having a first conductivity type) 15P formed on the insulating layer 14 while being in contact with the exposed portion 13E of the light transmissive electrode 13, a light-emitting layer (active layer) 15A formed on the p-type semiconductor layer 15P, and an n-type semiconductor layer (second semiconductor layer, which is a semiconductor layer having a second conductivity type opposite to the first conductivity type) 15N formed on the light-emitting layer 15A.

In this embodiment, the n-type semiconductor layer 15N has a GaN composition and contains Si as n-type impurities. The light-emitting layer 15A has a quantum well structure that includes a well layer having an InGaN composition and a barrier layer having a GaN composition. The p-type semiconductor layer 15P has a GaN-based composition and contains Mg as p-type impurities.

The configuration of the optical semiconductor layer 15 is not limited to this. For example, the n-type semiconductor layer 15N may have a plurality of n-type semiconductor layers having different compositions from one another. The light-emitting layer 15A may have a single quantum well structure or may have a single layer structure.

The p-type semiconductor layer 15P may have a plurality of p-type semiconductor layers having different compositions from one another. For example, the p-type semiconductor layer 15P may have a contact layer (not illustrated) for forming an ohmic contact with the light transmissive electrode 13. In this case, for example, it is only necessary for the p-type semiconductor layer 15P to have a GaN layer as a clad layer between the contact layer and the light-emitting layer 15A.

The optical semiconductor layer 15 may have, for example, between the light-emitting layer 15A and the p-type semiconductor layer 15P, an electron-blocking layer (not illustrated) that avoids electrons injected into the light-emitting layer 15A overflowing into the p-type semiconductor layer 15P. For example, the electron-blocking layer may have an AlGaN composition. The electron-blocking layer may contain impurities, and for example, may have p-type impurities and may have a p-type conductivity type.

The surface emitting laser 10 includes a second multilayer film reflecting mirror (hereinafter simply referred to as a second reflecting mirror) 16 formed on the optical semiconductor layer 15. The second reflecting mirror 16 is arranged opposed across the optical semiconductor layer 15 to the first reflecting mirror 12. Together with the first reflecting mirror 12, the second reflecting mirror 16 constitutes a resonator 10C having a direction perpendicular to the optical semiconductor layer 15 (direction perpendicular to the mount substrate 10M) as a resonator length direction.

In this embodiment, the second reflecting mirror 16 has a structure in which a first semiconductor film (hereinafter referred to as a low refractive index semiconductor film) 16L and a second semiconductor film (hereinafter referred to as a high refractive index semiconductor film) 16H having a higher refractive index than the low refractive index semiconductor film 16L are alternately laminated. That is, in this embodiment, the second reflecting mirror 16 constitutes a distributed Bragg reflector made of a semiconductor material.

For example, each of the low refractive index semiconductor film 16L and the high refractive index semiconductor film 16H in the second reflecting mirror 16 is made of the same kind of semiconductor material as the optical semiconductor layer 15, which is a nitride semiconductor material in this embodiment. For example, the low refractive index semiconductor film 16L is made of AlInN, and the high refractive index semiconductor film 16H is made of GaN.

Further, in this embodiment, the second reflecting mirror 16 has an n-type conductivity type. In this embodiment, each of the low refractive index semiconductor film 16L and the high refractive index semiconductor film 16H contains n-type impurities. For example, in this embodiment, the low refractive index semiconductor film 16L and the high refractive index semiconductor film 16H are an AlInN film and a GaN film that contain Si, respectively.

The surface emitting laser 10 includes a semiconductor substrate 17 formed on the second reflecting mirror 16. The semiconductor substrate 17 is made of the same kind of semiconductor material as the optical semiconductor layer 15 and the second reflecting mirror 16, which is a nitride semiconductor material in this embodiment. The semiconductor substrate 17 has a light-transmissive property to light emitted from the light-emitting layer 15A.

In this embodiment, the semiconductor substrate 17 is a growth substrate used for crystal growth of the optical semiconductor layer 15 and the second reflecting mirror 16. For example, the semiconductor substrate 17 has a GaN composition. Further, in this embodiment, a buffer layer (not illustrated) having a GaN composition is included between the semiconductor substrate 17 and the second reflecting mirror 16.

Further, in this embodiment, the semiconductor substrate 17 has an n-type conductivity type. In this embodiment, the semiconductor substrate 17 is made of a semiconductor material having n-type impurities, and is a GaN substrate containing Si in this embodiment.

The semiconductor substrate 17 has an upper surface 17S and a projecting portion 17P projecting from the upper surface 17S. The projecting portion 17P has a top surface 17PS that is mirror-finished by polishing. Further, the projecting portion 17P has a damage layer 17A that is formed in a region of a predetermined depth from the top surface 17PS and in which a conductive property is impaired by the polishing.

**In** this embodiment, the projecting portion 17P is a part projecting in a cylindrical shape from the upper surface 17S in the semiconductor substrate 17. The projecting portion 17P is formed so as to be arranged at a position where the central axis of the projecting portion 17P passes through the center of the exposed portion 13E in the light transmissive electrode 13 (that is, a contact region with the optical semiconductor layer 15). In this embodiment, the projecting portion 17P has a width (diameter) D2 larger than a width (diameter) D1 of the exposed portion 13E of the light transmissive electrode 13.

In this embodiment, the upper surface 17S of the semiconductor substrate 17 is a surface region of the semiconductor substrate 17 that has been removed by etching. More specifically, the upper surface 17S of the semiconductor substrate 17 is a surface region of the semiconductor substrate 17 that appears by removing the polished surface by dry etching after the polishing. Therefore, the upper surface 17S of the semiconductor substrate 17 is a region showing the n-type conductivity type. In this embodiment, the projecting portion 17P of the semiconductor substrate 17 is a surface region of the semiconductor substrate 17 in which the polished surface remains without being dry-etched.

The surface emitting laser 10 includes an n-electrode (second electrode) 18 that is formed on the upper surface 17S of the semiconductor substrate 17 and has an opening portion 18A surrounding the projecting portion 17P. In this embodiment, the n-electrode 18 is made of a metallic material, such as Au, Al, and Cu.

In this embodiment, the n-electrode 18 is formed on the semiconductor substrate 17 in a layered shape. The opening portion 18A of the n-electrode 18 has an opening width larger than the width of the projecting portion 17P of the semiconductor substrate 17 and is formed to be separated from the projecting portion 17P.

The surface emitting laser 10 has an anti-reflection layer 19 formed on the n-electrode 18 so as to bury the projecting portion 17P of the semiconductor substrate 17. The anti-reflection layer 19 is made of, for example, a dielectric multilayer film, and in this embodiment, has a structure in which a Ta₂O₅ layer and an SiO₂ layer are alternately laminated multiple times. The anti-reflection layer 19 suppresses reflection of the light emitted from the light-emitting layer 15A by the top surface 17PS of the projecting portion 17P of the semiconductor substrate 17.

In this embodiment, the exposed portion 13E of the light transmissive electrode 13 (that is, the opening portion 14A of the insulating layer 14) defines a luminescence center that is the center of a luminescence region of the light-emitting layer 15A and defines a center axis (hereinafter referred to as a luminescence center axis) AX of the resonator 10C. The luminescence center axis AX of the resonator 10C passes through the center of the exposed portion 13E of the light transmissive electrode 13 and extends along a direction perpendicular to the optical semiconductor layer 15.

The luminescence region of the light-emitting layer 15A is, for example, a region having a predetermined width where light having a predetermined intensity or higher is emitted within the light-emitting layer 15A, and the center of the luminescence region is the luminescence center. Further, for example, the luminescence region of the light-emitting layer 15A is a region into which a current having a predetermined density or higher is injected within the light-emitting layer 15A, and the center of the luminescence region is the luminescence center. A straight line perpendicular to the mount substrate 10M passing through the luminescence center is the luminescence center axis AX. The luminescence center axis AX is a straight line extending along the resonator length direction of the resonator 10C composed of the first reflecting mirror 12 and the second reflecting mirror 16. The luminescence center axis AX corresponds to an optical axis of a laser light exiting from the surface emitting laser 10.

**In** this embodiment, the second reflecting mirror 16 has a smaller light reflectivity than the first reflecting mirror 12. The second reflecting mirror 16 has a light-transmissive property to the light emitted from the light-emitting layer 15A. The second reflecting mirror 16 reflects most of the light emitted from the light-emitting layer 15A and transmits a part of a laser beam LB that has resonated in the resonator 10C to exit outside the resonator 10C.

Therefore, in this embodiment, the surface emitting laser 10 is configured to cause the laser beam LB generated in the resonator 10C to exit from the top surface 17PS of the projecting portion 17P of the semiconductor substrate 17.

In other words, the surface emitting laser 10 has a region of the projecting portion 17P of the semiconductor substrate 17 as a light extraction region and has a region of the upper surface 17S (which can be also referred to as a depressed portion region with respect to the projecting portion 17P) that is a region around the projecting portion 17P of the semiconductor substrate 17 as a contact region with the optical semiconductor layer 15.

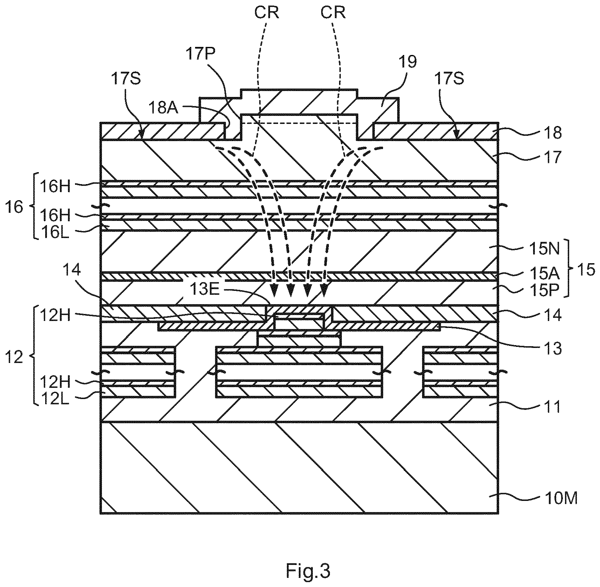

FIG. 3 is a drawing schematically illustrating a current path in the surface emitting laser 10. In this embodiment, as illustrated by dashed lines in FIG. 3, a current CR flowing between the light transmissive electrode 13 (p-electrode 11) and the n-electrode 18 flows along a direction approximately perpendicular to the optical semiconductor layer 15 and the second reflecting mirror 16 (hereinafter referred to as a longitudinal direction). The path of the current CR can be said to be a path in which an electrical resistance becomes the smallest when a current is injected into the optical semiconductor layer 15.

Specifically, first, in a case where opposed electrodes are arranged in the longitudinal direction similarly to the surface emitting laser 10, the distance between the electrodes becomes less than about 200 µm in many cases. This is because handling is impossible unless the surface emitting laser 10 itself has a mechanical strength to some extent, and accordingly, in general, approximately 80 to 200 µm needs to be left as a thickness of the semiconductor substrate 17.

On the other hand, provisionally, in a case where electrodes are arranged in a direction parallel to the optical semiconductor layer 15 (hereinafter referred to a lateral direction) by partially removing the optical semiconductor layer 15, and the like, the current flows in the direction parallel to the optical semiconductor layer 15. In this case, considering stable heat radiation characteristics and electrical characteristics, the distance of the current path between the electrodes becomes about 50 µm or more in many cases.

Here, the electrical resistance in the optical semiconductor layer 15 is proportional to the distance of the current path flowing in the optical semiconductor layer 15 and inversely proportional to a cross-sectional area of the current path. Then, in a case where the electrodes are arranged in the longitudinal direction, the cross-sectional area of the current path is large enough to cancel out the difference of the distances of the current path compared with a case where the electrodes are arranged in the lateral direction. For example, the cross-sectional area of the current path in the case of the electrode arrangement in the longitudinal direction is larger by double digits or more than the cross-sectional area of the current path in the case of the electrode arrangement in the lateral direction (which is a cross-sectional area significantly exceeding 100 times). Therefore, by arranging the electrodes in the longitudinal direction, the electrical resistance between the electrodes can be made much smaller than the case of the lateral direction.

Therefore, without being wasted in the optical semiconductor layer 15, the current CR is injected into the light-emitting layer 15A and converted into light with high efficiency. Therefore, the optical semiconductor layer 15 can perform a highly efficient light-emitting operation.

In this embodiment, the laser beam LB exits from the top surface 17PS of the projecting portion 17P of the semiconductor substrate 17 that is mirror-finished. This is the most preferable configuration in stabilizing an output power and a beam shape of the laser beam LB.

Specifically, considering that high electrical characteristics are obtained and the laser beam LB exits without lowering the output power in the case where the electrodes are arranged in the longitudinal direction similarly to the surface emitting laser 10, the semiconductor substrate 17 is preferably thin to some extent.

Further, considering that optical properties of the laser beam LB, such as the beam shape and an output distribution of the laser beam LB, are stabilized, the top surface 17PS of the projecting portion 17P that is an exiting surface of the laser beam LB is preferably highly flattened. In this case, for example, performing a mirror finishing process, such as polishing, is used after performing a processing that thins a growth substrate that becomes the semiconductor substrate 17.

However, the inventors of this application noted that performing the polishing has a disadvantage in which a region that does not have a conductive property is formed in a proximity of the polished surface of the growth substrate. Further, the inventors of this application confirmed by an experiment that conduction to the p-electrode 11 was not obtained when the n-electrode 18 was formed on the polished surface.

In contrast to this, in this embodiment, by removing the polished surface of the growth substrate excluding a part becoming a light exiting surface, a region of the upper surface 17S that is a surface region of the semiconductor substrate 17 other than a part that becomes an optical path of the laser beam LB is used as a contact region with the n-electrode 18. Therefore, sandwiching the optical semiconductor layer 15, a satisfactory path of the current CR in the longitudinal direction can be formed between the upper surface 17S of the semiconductor substrate 17 and the exposed portion 13E of the light transmissive electrode 13.

Therefore, the surface emitting laser 10 becomes a light-emitting element that can perform a highly efficient light-emitting operation by performing a highly efficient current injection. Further, the surface emitting laser 10 becomes a laser element that allows the stable laser beam LB to exit with high output power. By providing the anti-reflection layer 19 on the projecting portion 17P, the laser beam LB with high output power and optical properties can exit more stably.

The shape and size of the projecting portion 17P in the semiconductor substrate 17 can be designed based on, for example, the beam shape, a radiation angle, and the like of the laser beam LB. For example, setting the light-emitting layer 15A as an exiting point of the laser beam LB and considering the distance of the laser beam LB from the n-type semiconductor layer 15N to the top surface 17PS of the projecting portion 17P of the semiconductor substrate 17 and the radiation angle of the laser beam LB in the n-type semiconductor layer 15N, the second reflecting mirror 16, and the semiconductor substrate 17, the beam shape and the beam width (beam diameter) of the laser beam LB at the top surface 17PS of the projecting portion 17P of the semiconductor substrate 17 can be calculated.

In this embodiment, the height of the projecting portion 17P relative to the upper surface 17S in the semiconductor substrate 17 is larger than the thickness of the n-electrode 18 (height from the upper surface 17S). This suppresses absorption of an outer edge portion of the laser beam LB by the n-electrode 18 after the laser beam LB exits from the top surface 17PS of the projecting portion 17P. Therefore, the laser beam LB can stably exit with a designed beam shape and output power.

In this embodiment, the opening portion 18A of the n-electrode 18 has an opening diameter larger than the width D2 of the projecting portion 17P of the semiconductor substrate 17. Therefore, the n-electrode 18 is separated from the side surface of the projecting portion 17P. This is preferred in production of the n-electrode 18. Specifically, in a case where a metal layer that becomes the n-electrode 18 is formed by lift-off, burrs are generated at an end portion of the metal layer in some cases when the metal layer is lifted off. Even in this case, by forming the n-electrode 18 using a larger mask than the projecting portion 17P, formation of the burrs on the projecting portion 17P can be suppressed.

In this embodiment, the p-electrode 11 is in contact with approximately the whole surface of the mount substrate 10M. With this, the p-electrode 11 can form a heat radiation path for effectively conducting heat generated from the optical semiconductor layer 15 to the mount substrate 10M. Therefore, the surface emitting laser 10 becomes a light-emitting element that has a high heat radiation performance and stably operates even in a case of driving for a long time and with a large current.

In this embodiment, the p-electrode 11 passes through the first reflecting mirror 12 and is connected to the light transmissive electrode 13. Therefore, the path for effectively conducting the heat from the optical semiconductor layer 15 to the mount substrate 10M can be formed. The p-electrode 11 is formed so as to pass through the first reflecting mirror 12 in a tubular shape in a manner to surround the luminescence center axis AX. With this, a large heat radiation effect can be expected.

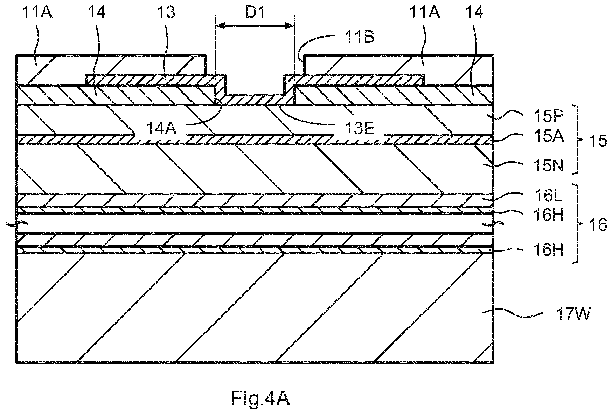

Each of FIG. 4A to Fig. 4H is a cross-sectional view illustrating a manufacturing process of the surface emitting laser 10. Using FIG. 4A to Fig. 4H, an example of a manufacturing method of the surface emitting laser 10 will be described. Each of FIG. 4A to Fig. 4H is a cross-sectional view similar to FIG. 2 in the manufacturing process of the surface emitting laser 10.

First, as illustrated in FIG. 4A, a growth substrate 17W that becomes the semiconductor substrate 17 is prepared, and the second reflecting mirror 16 and the optical semiconductor layer 15 are grown on the growth substrate 17W. For example, for the growth of the second reflecting mirror 16 and the optical semiconductor layer 15, a metal organic chemical vapor deposition (MOCVD method) can be used.

Specifically, first, an n-type GaN substrate having a flat plate shape was prepared as the growth substrate 17W. After an n-GaN layer as a buffer layer is grown on the GaN substrate, an n-GaN film as the high refractive index semiconductor film 16H and an n-AlInN film as the low refractive index semiconductor film 16L are alternately grown on the buffer layer multiple times. This forms the second reflecting mirror 16 on the growth substrate 17W.

Next, on the second reflecting mirror 16, an n-GaN layer as the n-type semiconductor layer 15N, a plurality of pairs of InGaN layer and GaN layer as the light-emitting layer 15A, and a p-GaN layer as the p-type semiconductor layer 15P are each grown. This forms the optical semiconductor layer 15 on the second reflecting mirror 16.

Subsequently, the insulating layer 14 is formed on the optical semiconductor layer 15. In this embodiment, on the p-type semiconductor layer 15P, an SiO₂ layer was formed, and an opening portion was formed in a part of the SiO₂ layer. This forms the insulating layer 14 having the opening portion 14A.

Next, the light transmissive electrode 13 is formed on the insulating layer 14. In this embodiment, ITO as the light transmissive electrode 13 was formed in a layered shape on the insulating layer 14 so as to be in contact with the upper surface of the p-type semiconductor layer 15P at the opening portion 14A of the insulating layer 14.

Subsequently, a layer-shaped electrode 11A constituting a part of the p-electrode 11 is formed on the insulating layer 14. In this embodiment, as the layer-shaped electrode 11A, a metal layer that has an opening portion 11B having an opening width larger than the width D1 of the opening portion 14A of the insulating layer 14 was formed. The opening portion 11B of the layer-shaped electrode 11A was arranged so as to overlap the opening portion 14A of the insulating layer 14 when viewed in a direction perpendicular to the layer-shaped electrode 11A (so as to surround the opening portion 14A in this embodiment).

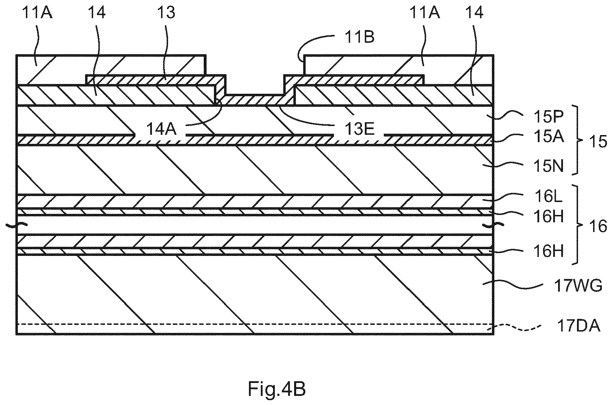

Next, as illustrated in FIG. 4B, the growth substrate 17W is cut and polished from the surface of the growth substrate 17W on the opposite side to the second reflecting mirror 16. Specifically, first, the growth substrate 17W is cut or severed to decrease the thickness of the growth substrate 17W. Then, a grinding and a polishing processes are performed on the cut surface. This forms a growth substrate 17WG in which the surface of the growth substrate 17W on the opposite side to the second reflecting mirror 16 is mirror-finished.

Here, by performing the polishing process of the growth substrate 17W, the n-type conductive property is impaired in a proximity of the surface that has been polished. Therefore, on the growth substrate 17WG after the polishing, a high resistance region that has a very high resistance and comes into non-ohmic contact even if the n-electrode is directly formed, that is, a surface region that becomes the damage layer 17A of the semiconductor substrate 17, is formed.

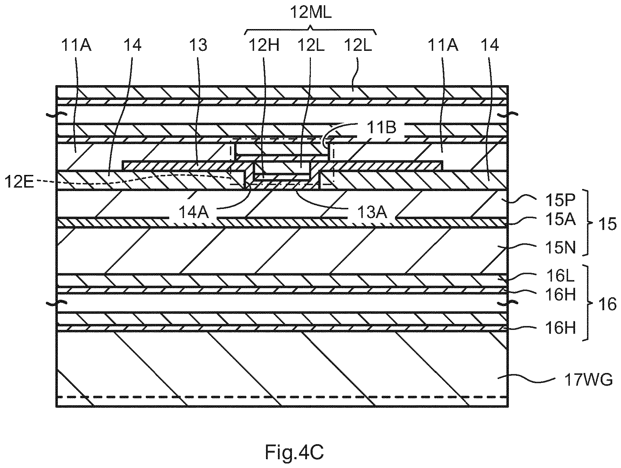

Subsequently, as illustrated in FIG. 4C, on the layer-shaped electrode 11A, a dielectric multilayer film 12ML composed of the high refractive index dielectric films 12H and the low refractive index dielectric films 12L, which becomes the first reflecting mirror 12, is formed so as to embed the opening portion 11B. In this embodiment, as the high refractive index dielectric film 12H and the low refractive index dielectric film 12L, an Nb₂O₅ film and an SiO₂ film Nb₂O₅ were alternately laminated multiple times, respectively.

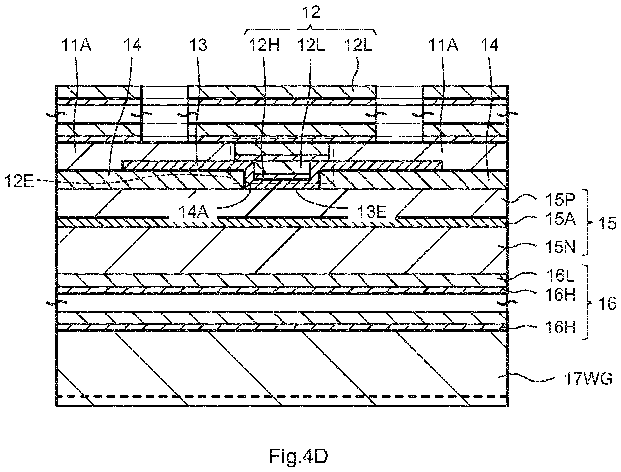

Next, as illustrated in FIG. 4D, a part of the dielectric multilayer film 12ML is removed to expose the layer-shaped electrode 11A. In this embodiment, a region on which the dielectric multilayer film 12ML is removed in a tubular shape is formed such that the opening portion 11B of the layer-shaped electrode 11A is surrounded in an annular shape by the part of the layer-shaped electrode 11A exposed from the dielectric multilayer film 12ML.

Further, in this embodiment, the dielectric multilayer film 12ML is removed such that the part of the layer-shaped electrode 11A exposed from the dielectric multilayer film 12ML is arranged in a region on the light transmissive electrode 13. By partially removing the dielectric multilayer film 12ML, the first reflecting mirror 12 is formed on the layer-shaped electrode 11A.

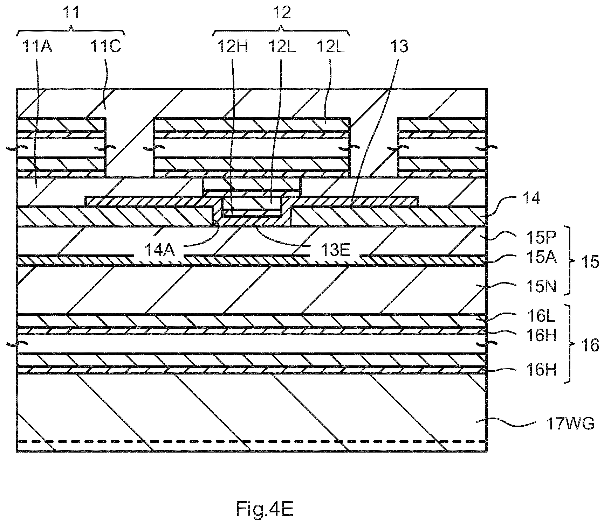

Subsequently, as illustrated in FIG. 4E, a burying electrode 11C constituting the p-electrode 11 is formed so as to bury the first reflecting mirror 12 and so as to be in contact with the layer-shaped electrode 11A exposed from the first reflecting mirror 12. The upper surface of the burying electrode 11C is flattened. The burying electrode 11C is made of, for example, a metallic material similar to the layer-shaped electrode 11A. With this, the whole of the layer-shaped electrode 11A and the burying electrode 11C becomes the p-electrode 11 that buries the first reflecting mirror 12 while partially exposing the first reflecting mirror 12.

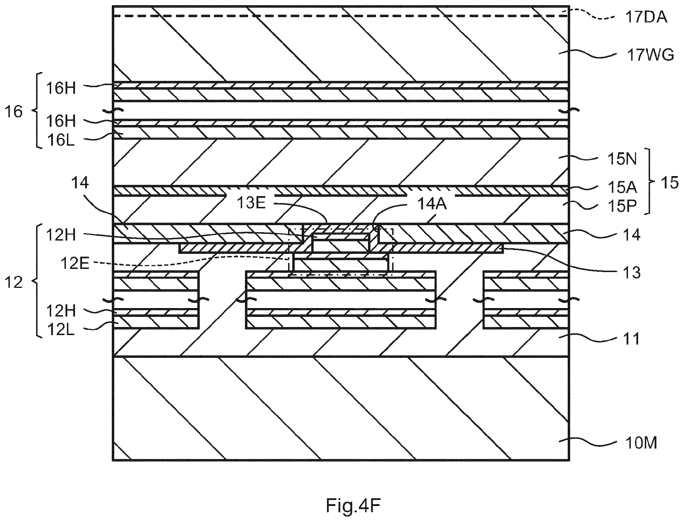

Next, as illustrated in FIG. 4F, the growth substrate 17WG is joined to the mount substrate 10M from the p-electrode 11 side. For example, after a ceramic substrate is prepared as the mount substrate 10M and a metal layer (not illustrated) is formed on the upper surface of the ceramic substrate, the p-electrode 11 is joined to the metal layer. With this, on the mount substrate 10M, the growth substrate 17WG is mounted together with the optical semiconductor layer 15, the first reflecting mirror 12, and the second reflecting mirror 16.

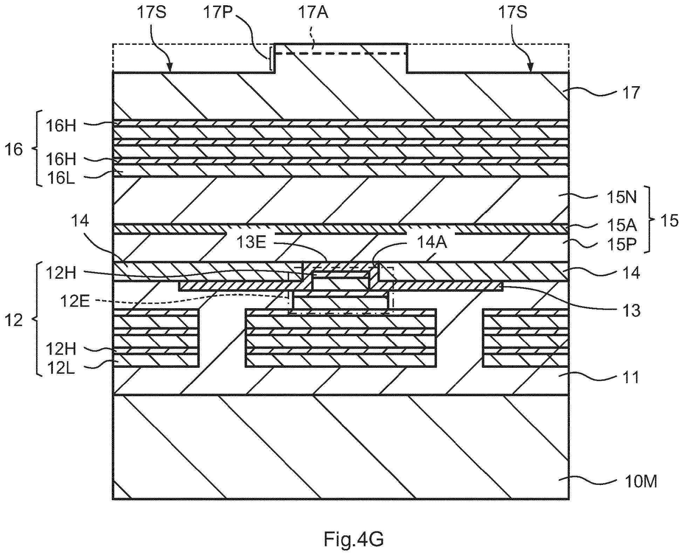

Subsequently, as illustrated in FIG. 4G, the growth substrate 17WG is partially removed from a damage region 17DA side. For example, for the partial removal of the growth substrate 17WG, a processing technique, such as dry etching, can be used. With this, the part that has not been removed of the growth substrate 17WG projects from the surface that has been removed and exposed.

Further, on the part that has not been removed, the damage region 17DA remains. On the other hand, the part that has been removed does not have the damage region 17DA and becomes a part showing the n-type conductivity type. This forms the semiconductor substrate 17 that has the upper surface 17S and the projecting portion 17P projecting from the upper surface 17S and has the damage layer 17A on the upper surface of the projecting portion 17P.

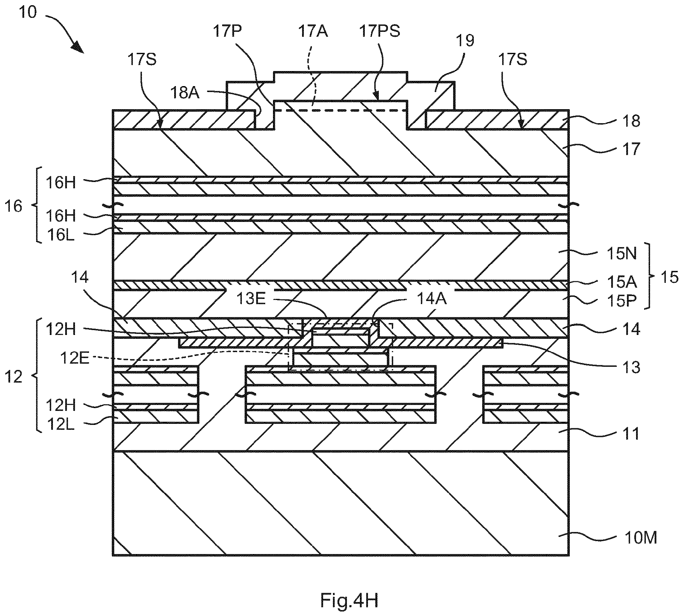

Next, as illustrated in FIG. 4H, a metal layer is formed on the semiconductor substrate 17, and an opening portion that exposes the projecting portion 17P is formed on the metal layer. This forms the n-electrode 18. By forming a multilayer film of dielectric material on the n-electrode 18 while embedding the projecting portion 17P of the semiconductor substrate 17, the anti-reflection layer 19 is formed. The surface emitting laser 10 can be manufactured, for example, in this way.

In this embodiment, a case where the semiconductor substrate 17 has the top surface 17PS that is mirror-finished on the projecting portion 17P and has the damage layer 17A in which a conductive property is impaired in a proximity of the top surface 17PS has been described. However, the configuration of the semiconductor substrate 17 is not limited to this. It is only necessary for the semiconductor substrate 17 to at least have the upper surface 17S on which the n-electrode 18 is formed and the projecting portion 17P that projects from the upper surface 17S and functions as a light exiting surface. This allows a conduction in the longitudinal direction via the semiconductor substrate 17 and a satisfactory light to exit from the projecting portion 17P.

In this embodiment, a case where the upper surface 17S that is the surface region other than the projecting portion 17P in the semiconductor substrate 17 is a surface region of the semiconductor substrate 17 that appears by dry etching has been described. However, it is only necessary for the upper surface 17S of the semiconductor substrate 17 to be a surface region showing the n-type conductivity type, and a forming method of the upper surface 17S is not limited to etching.

In this embodiment, a case where the first reflecting mirror 12 is formed so as to be embedded in the p-electrode 11 and has the exposed portion 12E projecting and exposed from the p-electrode 11 has been described. Further, a case where the light transmissive electrode 13 is connected to the p-electrode 11 has been described. However, the configurations of the p-electrode 11, the first reflecting mirror 12, and the light transmissive electrode 13 are not limited to these.

For example, it is only necessary for the surface emitting laser 10 to at least have the first reflecting mirror 12 and the light transmissive electrode 13 that functions as a p-side electrode formed on the first reflecting mirror 12. Further, a case where the insulating layer 14 is disposed on the light transmissive electrode 13 has been described. However, the insulating layer 14 does not have to be disposed. For example, as long as a part of a region on the light transmissive electrode 13 on the p-type semiconductor layer 15P is lowered in resistance, this region functions as a current injection region. Further, the anti-reflection layer 19 does not have to be disposed.

Thus, in this embodiment, the surface emitting laser 10 includes the first reflecting mirror 12, the light transmissive electrode (first electrode) 13, the p-type semiconductor layer 15P (first semiconductor layer), the light-emitting layer 15A, the n-type semiconductor layer 15N, the second reflecting mirror 16, the semiconductor substrate 17, and the n-electrode 18. The light transmissive electrode 13 is formed on the first reflecting mirror 12. The p-type semiconductor layer 15P is formed on the light transmissive electrode 13. The light-emitting layer 15A is formed on the p-type semiconductor layer 15P. The n-type semiconductor layer 15N is formed on the light-emitting layer 15A. The second reflecting mirror 16 is formed on the n-type semiconductor layer 15N and composed of a plurality of semiconductor films having the n-type conductivity type (second conductivity type). The semiconductor substrate 17 is formed on the second reflecting mirror 16, has the upper surface 17S and the projecting portion 17P projecting from the upper surface 17S, and has the n-type conductivity type. The n-electrode 18 is formed on the upper surface 17S of the semiconductor substrate 17. Therefore, the surface emitting laser 10 (vertical cavity light-emitting element) that performs a highly efficient light-emitting operation by performing a highly efficient current injection can be provided.

### [Embodiment 2]

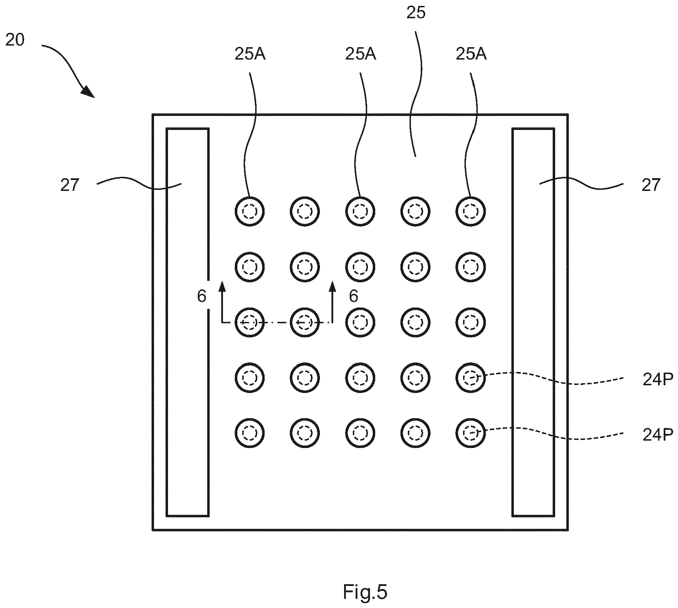

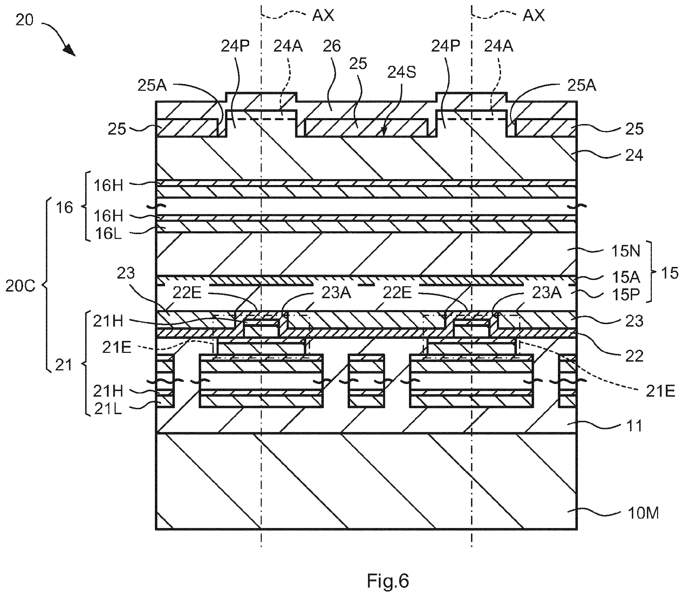

FIG. 5 is a top view of a surface emitting laser 20 according to Embodiment 2. FIG. 6 is a cross-sectional view taken along the line 6-6 in Fig. 5, which is a cross-sectional view of the surface emitting laser 20. Using FIG. 5 and FIG. 6, a configuration of the surface emitting laser 20 will be described.

**In** this embodiment, the surface emitting laser 20 includes a first reflecting mirror 21 having a plurality of exposed portions 21E, an insulating layer 23 having a plurality of opening portions 23A corresponding to the respective exposed portions 21E, a light transmissive electrode 22 having a plurality of exposed portions 22E, and a semiconductor substrate 24 having a plurality of projecting portions 24P. That is, the surface emitting laser 20 has a plurality of light exiting portions and has a plurality of luminescence center axes AX.

More specifically, the first reflecting mirror 21 has a structure in which a low refractive index dielectric film 21L and a high refractive index dielectric film 21H that are respectively similar to the low refractive index dielectric film 12L and the high refractive index dielectric film 12H in the first reflecting mirror 12 are alternately laminated. The first reflecting mirror 21 has a plurality of exposed portions 21E that are each exposed from the p-electrode 11. In this embodiment, the first reflecting mirror 21 constitutes a resonator 20C together with the second reflecting mirror 16.

The light transmissive electrode 22 is formed on the first reflecting mirror 21 while covering each of the plurality of exposed portions 21E of the first reflecting mirror 21. The insulating layer 23 has the opening portions 23A that expose the light transmissive electrode 22 at regions on the exposed portions 21E of the first reflecting mirror 21 in the light transmissive electrode 22. With this, the light transmissive electrode 22 has the plurality of exposed portions 22E that are each exposed from the insulating layer 23. That is, on the p-type semiconductor layer 15P of the optical semiconductor layer 15, a plurality of contact regions with the light transmissive electrode 22 are formed.

The semiconductor substrate 24 has an upper surface 24S and the plurality of projecting portions 24P that are formed on the respective plurality of exposed portions 22E of the light transmissive electrode 22 and each exposed from the upper surface 24S. Each of the projecting portions 24P has a damage layer 24A in a proximity of its upper surface.

The surface emitting laser 20 has an n-electrode 25 that is formed on the upper surface 24S of the semiconductor substrate 24 and has a plurality of opening portions 25A surrounding the respective plurality of projecting portions 24P. The surface emitting laser 20 has an anti-reflection layer 26 formed so as to cover the projecting portions 24P of the semiconductor substrate 24 and the n-electrode 25. The surface emitting laser 20 includes pad electrodes 27 connected to the n-electrode 25.

In this embodiment, the surface emitting laser 20 includes the plurality of projecting portions 24P of the semiconductor substrate 24 as the exiting portions of the laser beam LB. Even in the surface emitting laser 20, by using the region other than the projecting portions 24P of the semiconductor substrate 24 as a contact region with the n-electrode 25, a satisfactory conduction in the longitudinal direction can be formed, and a highly efficient current injection to the optical semiconductor layer 15 can be performed. Therefore, the surface emitting laser 20 (vertical cavity light-emitting element) that performs a highly efficient light-emitting operation by performing a highly efficient current injection can be provided.

### REFERENCE SIGNS LIST

- 10, 20: surface emitting laser (VCSEL)
- 11: p-electrode (connection electrode)
- 12, 21: first reflecting mirror
- 13, 22: light transmissive electrode (first electrode)
- 15: optical semiconductor layer
- 16: second reflecting mirror
- 17, 24: semiconductor substrate
- 18, 25: n-electrode

## Claims

1. A vertical cavity light-emitting element (10) comprising:
a first multilayer film reflecting mirror (12);
a light transmissive first electrode (13) formed on the first multilayer film reflecting mirror (12);
a first semiconductor layer (15P) formed on the first electrode (13) and having a first conductivity type;
a light-emitting layer (15A) formed on the first semiconductor layer (15P);
a second semiconductor layer (15N) formed on the light-emitting layer (15A) and having a second conductivity type opposite to the first conductivity type;
a second multilayer film reflecting mirror (16) formed on the second semiconductor layer (15N) and composed of a plurality of semiconductor layers having the second conductivity type, the second multilayer film reflecting mirror (16) constituting a resonator (10C) together with the first multilayer film reflecting mirror (12);
a semiconductor substrate (17) formed on the second multilayer film reflecting mirror (16), having an upper surface (17S) and a projecting portion (17P) projecting from the upper surface (17S), and having the second conductivity type; and
a second electrode (18) formed on the upper surface (17S) of the semiconductor substrate (17);
**characterized in that**
the projecting portion (17P) of the semiconductor substrate (17) has a top surface (17PS) that is mirror-finished by polishing; and
the projecting portion (17P) of the semiconductor substrate (17) has a damage layer (17A) formed along the top surface (17PS) of the projecting portion (17P), and the damage layer (17A) has the second conductivity type impaired by the polishing.

2. The vertical cavity light-emitting element (10) according to claim 1, wherein
the upper surface (17S) of the semiconductor substrate (17) is a surface region of the semiconductor substrate (17) from which the polished surface is removed by etching after the polishing.

3. The vertical cavity light-emitting element (10) according to claim 1 or 2, wherein
the second multilayer film reflecting mirror (16) has a smaller reflectance to light emitted from the light-emitting layer (15A) than the first multilayer film reflecting mirror (12).

4. The vertical cavity light-emitting element (10) according to any one of claims 1 to 3, comprising
a connection electrode (11) formed on the first multilayer film reflecting mirror (12) so as to embed the first multilayer film reflecting mirror (12) and connected to the first electrode (13).

5. The vertical cavity light-emitting element (10) according to claim 4, wherein
the connection electrode (11) passes through the first multilayer film reflecting mirror (12) and is connected to the first electrode (13).

6. The vertical cavity light-emitting element (10) according to claim 4 or 5, wherein
the first multilayer film reflecting mirror (12) has a buried multilayer film part embedded in the connection electrode (11) and a projecting multilayer film part projecting so as to decrease in width in stages from the buried multilayer film part.

7. The vertical cavity light-emitting element (10) according to any one of claims 1 to 6, comprising
an anti-reflection layer (19) formed so as to cover the projecting portion (17P) of the semiconductor substrate (17).

8. The vertical cavity light-emitting element (10) according to any one of claims 1 to 7, wherein
the second electrode (18) is formed to be separated from the projecting portion (17P).

9. The vertical cavity light-emitting element (10) according to any one of claims 1 to 8, wherein
a region of the upper surface (17S) that is a surface region of the semiconductor substrate (17) is used as a contact region with the semiconductor substrate (17) and the second electrode (18).

## Patentansprüche

1. Ein lichtemittierendes Element (10) mit vertikalem Hohlraum, das Folgendes aufweist:
einen ersten mehrschichtigen Film-Reflexionsspiegel (12);
eine lichtdurchlässige erste Elektrode (13), die auf dem ersten mehrschichtigen Film-Reflexionsspiegel (12) ausgebildet ist;
eine erste Halbleiterschicht (15P), die auf der ersten Elektrode (13) ausgebildet ist und einen ersten Leitfähigkeitstyp aufweist;
eine lichtemittierende Schicht (15A), die auf der ersten Halbleiterschicht (15P) ausgebildet ist;
eine zweite Halbleiterschicht (15N), die auf der lichtemittierenden Schicht (15A) ausgebildet ist und einen zweiten Leitfähigkeitstyp aufweist, der dem ersten Leitfähigkeitstyp entgegengesetzt ist;
einen zweiten Mehrschichtfilm-Reflexionsspiegel (16), der auf der zweiten Halbleiterschicht (15N) ausgebildet ist und aus einer Vielzahl von Halbleiterschichten mit dem zweiten Leitfähigkeitstyp besteht, wobei der zweite Mehrschichtfilm-Reflexionsspiegel (16) zusammen mit dem ersten Mehrschichtfilm-Reflexionsspiegel (12) einen Resonator (10C) bildet;
ein Halbleitersubstrat (17), das auf dem zweiten mehrschichtigen Film-Reflexionsspiegel (16) ausgebildet ist, eine obere Oberfläche (17S) und einen vorstehenden Abschnitt (17P) aufweist, der von der oberen Oberfläche (17S) vorsteht, und den zweiten Leitfähigkeitstyp aufweist; und
eine zweite Elektrode (18), die auf der oberen Oberfläche (17S) des Halbleitersubstrats (17) ausgebildet ist;
**dadurch gekennzeichnet, dass**
der vorstehende Abschnitt (17P) des Halbleitersubstrats (17) eine durch Polieren hochglanzpolierte obere Oberfläche (17PS) aufweist; und
der vorstehende Abschnitt (17P) des Halbleitersubstrats (17) eine entlang der oberen Oberfläche (17PS) des vorstehenden Abschnitts (17P) ausgebildete Schadensschicht (17A) aufweist, und die Schadensschicht (17A) den zweiten Leitfähigkeitstyp aufweist, der durch das Polieren beeinträchtigt ist.

2. Das lichtemittierende Element (10) mit vertikalem Hohlraum nach Anspruch 1, wobei
die obere Oberfläche (17S) des Halbleitersubstrats (17) ein Oberflächenbereich des Halbleitersubstrats (17) ist, von dem die polierte Oberfläche nach dem Polieren durch Ätzen entfernt wird.

3. Das lichtemittierende Element (10) mit vertikalem Hohlraum gemäß Anspruch 1 oder 2, wobei
der zweite Mehrschichtfilm-Reflexionsspiegel (16) eine geringere Reflexion für von der lichtemittierenden Schicht (15A) emittiertes Licht aufweist als der erste Mehrschichtfilm-Reflexionsspiegel (12).

4. Das lichtemittierende Element (10) mit vertikalem Hohlraum gemäß einem der Ansprüche 1 bis 3, das ferner eine Verbindungselektrode (11) aufweist, die auf dem ersten Mehrschichtfilm-Reflexionsspiegel (12) ausgebildet ist, um den ersten Mehrschichtfilm-Reflexionsspiegel (12) einzubetten, und die mit der ersten Elektrode (13) verbunden ist.

5. Das lichtemittierende Element (10) mit vertikalem Hohlraum nach Anspruch 4, wobei
die Verbindungselektrode (11) durch den ersten Mehrschichtfilm-Reflexionsspiegel (12) hindurchgeht und mit der ersten Elektrode (13) verbunden ist.

6. Das lichtemittierende Element (10) mit vertikalem Hohlraum nach Anspruch 4 oder 5, wobei
der erste Mehrschichtfilm-Reflexionsspiegel (12) einen vergrabenen bzw. versenkten Mehrschichtfilmteil, der in die Verbindungselektrode (11) eingebettet ist, und einen vorstehenden Mehrschichtfilmteil aufweist, der so vorsteht, dass er in der Breite stufenweise vom vergrabenen bzw. versenkten Mehrschichtfilmteil abnimmt.

7. Das lichtemittierende Element (10) mit vertikalem Hohlraum gemäß einem der Ansprüche 1 bis 6, das ferner eine Antireflektionsschicht (19) aufweist, die so ausgebildet ist, dass sie den vorstehenden Abschnitt (17P) des Halbleitersubstrats (17) bedeckt.

8. Das lichtemittierende Element (10) mit vertikalem Hohlraum gemäß einem der Ansprüche 1 bis 7, wobei
die zweite Elektrode (18) so ausgebildet ist, dass sie von dem vorstehenden Abschnitt (17P) getrennt ist.

9. Das lichtemittierende Element (10) mit vertikalem Hohlraum gemäß einem der Ansprüche 1 bis 8, wobei
ein Bereich der oberen Oberfläche (17S), der ein Oberflächenbereich des Halbleitersubstrats (17) ist, als Kontaktbereich mit dem Halbleitersubstrat (17) und der zweiten Elektrode (18) verwendet wird.

## Revendications

1. Élément émetteur de lumière à cavité verticale (10) comprenant :
un premier miroir réfléchissant à film multicouche (12) ;
une première électrode (13) transmettant la lumière, formée sur le premier miroir réfléchissant à film multicouche (12) ;
une première couche semi-conductrice (15P) formée sur la première électrode (13) et présentant un premier type de conductivité ;
une couche émettrice de lumière (15A) formée sur la première couche semi-conductrice (15P) ;
une deuxième couche semi-conductrice (15N) formée sur la couche émettrice de lumière (15A) et présentant un deuxième type de conductivité opposé au premier type de conductivité ;
un deuxième film multicouche réfléchissant (16) formé sur la deuxième couche semi-conductrice (15N) et composé d'une pluralité de couches semi-conductrices ayant le deuxième type de conductivité, le deuxième film multicouche réfléchissant (16) constituant un résonateur (10C) avec le premier film multicouche réfléchissant (12) ;
un substrat semi-conducteur (17) formé sur le deuxième film multicouche réfléchissant (16), ayant une surface supérieure (17S) et une partie saillante (17P) faisant saillie à partir de la surface supérieure (17S), et
ayant le deuxième type de conductivité ; et
une deuxième électrode (18) formée sur la surface supérieure (17S) du substrat semi-conducteur (17) ;
**caractérisé en ce que**
la partie saillante (17P) du substrat semi-conducteur (17) a une surface supérieure (17PS) qui est finie miroir par polissage ; et
la partie saillante (17P) du substrat semi-conducteur (17) comporte une couche endommagée (17A) formée le long de la surface supérieure (17PS) de la partie saillante (17P), et la couche endommagée (17A) présente le deuxième type de conductivité altéré par le polissage.

2. Élément émetteur de lumière à cavité verticale (10) selon la revendication 1, dans lequel
la surface supérieure (17S) du substrat semi-conducteur (17) est une zone de surface du substrat semi-conducteur (17) dont la surface polie est enlevée par gravure après le polissage.

3. Élément émetteur de lumière à cavité verticale (10) selon la revendication 1 ou 2, dans lequel
le deuxième miroir réfléchissant à film multicouche (16) a un coefficient de réflexion sur la lumière émise par la couche électroluminescente (15A) inférieur à celui du premier miroir réfléchissant à film multicouche (12).

4. Élément émetteur de lumière à cavité verticale (10) selon l'une quelconque des revendications 1 à 3, comprenant
une électrode de connexion (11) formée sur le premier miroir réfléchissant à film multicouche (12) de manière à encastrer le premier miroir réfléchissant à film multicouche (12) et connectée à la première électrode (13).

5. Elément émetteur de lumière à cavité verticale (10) selon la revendication 4, dans lequel
l'électrode de connexion (11) traverse le premier miroir réfléchissant multicouche (12) et est reliée à la première électrode (13).

6. Elément émetteur de lumière à cavité verticale (10) selon la revendication 4 ou 5, dans lequel
le premier miroir réfléchissant à film multicouche (12) comporte une partie de film multicouche enfouie dans l'électrode de connexion (11) et une partie de film multicouche en saillie dont la largeur diminue par paliers à partir de la partie de film multicouche enfouie.

7. Élément émetteur de lumière à cavité verticale (10) selon l'une quelconque des revendications 1 à 6, comprenant
une couche antireflet (19) formée de manière à couvrir la partie saillante (17P) du substrat semi-conducteur (17).

8. Élément émetteur de lumière à cavité verticale (10) selon l'une quelconque des revendications 1 à 7, dans lequel la deuxième électrode (18) est formée pour être séparée de la partie saillante (17P).

9. Élément émetteur de lumière à cavité verticale (10) selon l'une quelconque des revendications 1 à 8, dans lequel une région de la surface supérieure (17S) qui est une région de surface du substrat semi-conducteur (17) est utilisée comme région de contact avec le substrat semi-conducteur (17) et la deuxième électrode (18).
